# EUROPEAN PATENT APPLICATION

(11) **EP 0 851 297 A1**
(43) Date of publication of application: **01.07.1998**
(21) Application number: 97122388.8
(22) Date of filing: 18.12.1997
(51) Int. Cl.: G03F 7/004

(54) **Radiation-sensitive composition adapted for roller coating**

(30) Priority: 26.12.1996 JP 347577/96
(71) Applicant: CLARIANT INTERNATIONAL LTD., 4132 Muttenz (CH)
(72) Inventor: Susukida, Kenji, Ogasa-gun, Shizuoka (JP)
(74) Representative: Hütter, Klaus, Dr.

(57) **Abstract**

A radiation-sensitive composition adapted for roller coating is disclosed, which contains, as a solvent for the composition, a mixed solvent of at least one member selected from the group consisting of propylene glycol alkyl ethers and propylene glycol diacetate having a boiling point of 170 to 250 °C, kinematic viscosity of 2 cSt or more at 25 °C and a relative evaporation rate of 10 or less taking the evaporation rate of n-butyl acetate as 100, and other solvent or solvents. This composition forms less uneven coating upon being coated on a substrate by roller coating. The propylene glycol alkyl ethers are exemplified by propylene glycol phenyl ether, tripropylene glycol methyl ether, dipropylene glycol n-butyl ether, dipropylene glycol methyl ether, propylene glycol n-butyl ether, etc. and other solvents are exemplified by propylene glycol monomethyl ether acetate, propylene glycol monomethyl ether, ethylene glycol monoethyl ether acetate, ethylene glycol monobutyl ether, ethyl lactate, n-butyl acetate, etc.

## Description

### Background of the Invention

This invention relates to a radiation-sensitive composition adapted for roller coating and, more particularly, to a radiation-sensitive composition which can provide a resist layer with scarcely forming uneven coating when coated by roller coating method.

In manufacturing semiconductor integrated circuit elements, color filters, liquid crystal display elements, etc., lithographic technique has conventionally been employed for conducting fine work. In recent years, techniques enabling fine work on the order of sub-micron or sub-quarter micron have been investigated. In such lithographic technique, a positive- or negative-working, radiation-sensitive composition is coated on a substrate directly or after forming thereon an anti-reflective coating, and the coated composition is prebaked to form a radiation-sensitive resist layer. Then, this radiation-sensitive resist layer is patternwise exposed by various radiations such as ultraviolet rays, deep ultraviolet rays, electron beams, X-rays or the like, and developed to form a resist pattern. As the method for coating the radiation-sensitive composition, there have conventionally been known various methods such as spin coating method, roller coating method, cast coating method, doctor coating method, dip coating method, etc. In manufacturing semiconductor integrated circuits, for example, a positive-working radiation-sensitive composition is employed as a resist material and, as a coating method, spin coating method is often employed. On the other hand, in manufacturing liquid crystal display, too, a positive-working radiation sensitive composition is often employed and, as a coating method, roller coating method is employed as well as spin coating method. By the way, in the spin coating method, a resist solution dropped onto a substrate is cast in the peripheral direction of the substrate by the centrifugal force produced by the rotation of the substrate, with most of the resist solution being removed out of the periphery. The thus-removed resist solution is discarded. Thus, while this spin coating method enables one to form a resist layer of uniform thickness with ease, it has the defect that the amount of discarded resist solution is so large that it imposes high cost. On the other hand, roller coating method, which can utilize most of the resin used as a resist layer, serves to reduce manufacture cost, but has the defect that there arises uneven coating such as streaks and orange peel. For example, liquid crystal display elements manufactured using a resist layer having the coating defect of streaks provide non-uniform light areas, thus having no commercial values. Therefore, there has been required a radiation-sensitive composition which does not cause uneven coating streaks.

### Summary of the Invention

It is an object of the present invention to provide a radiation-sensitive composition adapted for roller coating, which does not have the defects with the conventional compositions as described above and, to be specific, to provide a radiation-sensitive composition which, upon being coated by roller coating method, scarcely causes uneven coating.

Other objects, features and advantages of the present invention will become apparent from the detailed descriptions of the preferred embodiments of the invention to follow.

As a result of intensive investigations, the inventor has found that the above-described objects can be attained by using, as a solvent for the radiation-sensitive composition, a mixed solvent which consists of at least one selected from among propylene glycol alkyl ethers having a boiling point of 170 to 250°C, kinematic viscosity of 2 cSt or more at 25°C , and relative evaporation rate of 10 or less taking evaporation rate of n-butyl acetate as 100 and propylene glycol diacetate, and other solvent, thus having completed the present invention based on the finding.

That is, the present invention is a radiation-sensitive composition adapted for roller coating and having improved coating properties, which comprises using, as a solvent for the radiation-sensitive composition, a mixed solvent which consists of at least one selected from among propylene glycol alkyl ethers, having a boiling point of 170 to 250°C, kinematic viscosity of 2 cSt or more at 25°C, and relative evaporation rate of 10 or less taking evaporation rate of n-butyl acetate as 100 and propylene glycol diacetate (PGDA), and other solvent.

### Detailed Description of the Preferred Embodiments of the Invention

As the propylene glycol alkyl ethers having a boiling point of 170 to 250°C, kinematic viscosity of 2 cSt or more at 25°C, and relative evaporation rate of 10 or less taking evaporation rate of n-butyl acetate as 100 to be used in the radiation-sensitive composition of the present invention adapted for roller coating, any propylene glycol alkyl ether may be used that satisfies these requirements and, especially, propylene glycol phenyl ether (PPh), tripropylene glycol methyl ether (TPM), dipropylene glycol n-butyl ether (DPnB), dipropylene glycol methyl ether (DPM), and propylene glycol n-butyl ether (PnB) are preferable. The solvents having the above-described properties may be used alone or in combination of two or more.

As the other solvents to be used in combination with at least one of the above-described propylene glycol alkyl ethers and propylene glycol diacetate, any solvent that has conventionally been or can be used as a solvent for radiation-sensitive compositions may be used. Preferable examples thereof include propylene glycol monomethyl ether acetate (PGMEA), propylene glycol monomethyl ether (PGME), ethylene glycol monoethyl ether acetate (EGA), ethylene glycol monobutyl ether, ethyl lactate (EL), and n-butyl acetate (nBA). These "other" solvents may be used alone or in combination of two or more of them. As to the mixing ratio of at least one member selected from among the propylene glycol alkyl ethers and propylene glycol diacetate to the other solvent, it varies depending upon the kinds of the solvents used but, in view of coating and drying properties, at least one selected from among the propylene glycol alkyl ethers and propylene glycol diacetate is preferably used in a total amount of 5 to 50 % by weight, more preferably 30 to 40 % by weight.

The reason why coating properties can be improved in the present invention by using, as a solvent for the radiation-sensitive composition, a mixed solvent which consists of at least one member selected from among propylene glycol alkyl ethers having a boiling point of 170 to 250°C, kinematic viscosity of 2 cSt or more at 25°C, and relative evaporation rate of 10 or less taking evaporation rate of n-butyl acetate as 100 and propylene glycol diacetate may be assumed as follows.

That is, in ordinary lithographic technique, a radiation-sensitive composition containing a solvent is coated on a substrate, then prebaked to form a radiation-sensitive resist layer. When the radiation-sensitive composition contains the solvent prior to the prebaking step, the composition shows good self-leveling properties but, since evaporation of the solvent initiates immediately after coating, the leveling properties are usually decreased sharply. When at least one selected from among the propylene glycol alkyl ethers and propylene glycol diacetate is used as part of the solvent, evaporation of the solvent prior to the prebaking step can be considerably depressed due to the comparatively high boiling point and small relative evaporation rate, thus self-leveling properties of the radiation-sensitive composition being maintained and the radiation-sensitive composition coated on a substrate leveling with the lapse of time.

In addition, in uniformly coating a radiation-sensitive composition on a substrate, it is necessary to design kinematic viscosity of the composition to be in a definite range. Use of a solvent having comparatively high kinematic viscosity such as propylene glycol alkyl ethers or propylene glycol diacetate enables one to reduce the solid concentration of radiation-sensitive composition owing to the solvent properties. In order to obtain a desired coating thickness after prebaking, a radiation-sensitive composition having a lower solid concentration must be coated in a larger quantity and, with such composition, there is obtained a better self-leveling property than in coating in a small amount due to the increase in fluidity. The above-described reasons are merely presumption of the inventor, and are not to be construed as limiting the present invention.

Physical properties of the above-described preferred illustrative compounds of the propylene glycol alkyl ethers, propylene glycol diacetate, and other solvents are tabulated in Table 1.

**Table 1**

| Solvent | | b.p. (°C) | Relative Evaporation Rate(n-Butyl acetate 100) | Viscosity (cSt/25°C) |
|---|---|---|---|---|
| PPh | propylene glycol phenyl ether | 243 | 1 | 23.76 |
| TPM | tripropylene glycol methyl ether | 242 | <1 | 5.53 |
| DPnB | dipropylene glycol n-butyl ether | 229 | 1 | 4.85 |
| PGDA | propylene glycol diacetate | 190 | 4 | 2.47 |
| DPM | diplopylene glycol methyl ether | 188 | 3 | 3.82 |
| PnB | propylene glycol n-butyl ether | 170 | 7 | 3.25 |
| PGMEA | propylene glycol monomethyl ether acetate | 146 | 34 | 1.13 |
| PGME | propylene glycol monomethyl ether | 120 | 70 | 1.8 |
| EGA (ECA) | ethylene glycol monoethyl ether acetate | 156 | 20 | 1.1 |
| Butycello | ethylene glycol monobutyl ether acetate | 170 | 6 | 3.15cP |
| EL | ethyl lactate | 155 | 22 | 2.41cP |
| nBA | n-butyl acetate | 126 | 100 | 0.68cP |

On the other hand, radiation-sensitive materials to be used in the radiation-sensitive composition of the present invention may be any of known or well known, positive- or negative-working resist materials. Typical examples of the radiation-sensitive materials to be used in the present invention include positive-working ones such as a resist comprising an alkali-soluble resin and a quinonediazide compound, a chemically amplified resist, etc. and negative-working ones such as a resist containing a photosensitive group-having high molecular compound (e.g.,polyvinyl cinnamate), a resist containing an aromatic azide, or a combination of cyclized rubber and a bisazide compound, a resist containing a diazo resin, a photopolymerizable composition containing an addition-polymerizable unsaturated compound, and a chemically amplified negative-working resist consisting of an alkali soluble resin, a cross linking agent and acid generator.

The radiation-sensitive material comprising an alkali-soluble resin and a quinonediazide compound is one of preferred materials for constituting the radiation-sensitive composition of the present invention. Several examples of the alkali-soluble resin and the quinonediazide compound are illustrated below. That is, as the alkali-soluble resin, there are illustrated novolak resin, polyvinylphenol, polyvinyl alcohol, copolymers of acrylic acid or methacrylic acid, etc. The novolak resin is exemplified by a polycondensation product between one or more of phenols such as phenol, o-cresol, m-cresol, p-cresol, xylenol, trimethylphenol, t-butylphenol, ethylphenol, 2-naphthol or 1,3-dihydroxynaphthalene and an aldehyde such as formaldehyde or para-formaldehyde. These alkali-soluble resins such as the novolak resin may be used in combination of two or more, if necessary.

Examples of the quinonediazide compound include 1,2-benzoquinonediazide-4-sulfonic acid, 1,2-naphthoquinonediazide-4-sulfonic acid, 1,2-naphthoquinonediazide-5-sulfonic acid, esters or amides of these sulfonic acids, etc. The sulfonic acid esters or amides of the quinonediazides can be obtained by the condensation reaction between a corresponding quinonediazide sulfonic acid or quinonediazidesulfonyl chloride and a hydroxyl group-having compound or an amino group-having compound. As the hydroxyl group-containing compound, there are illustrated dihydroxybenzophenone, trihydroxybenzophenone, tetrahydroxybenzophenone, pentahydroxybenzophenone, phenol, naphthol, p-methoxyphenol, bisphenol A, pyrocatechol, pyrogallol, pyrogallol methyl ether, gallic acid, α , α ', α ''-tris(4-hydroxyphenyl)-1,3,5-triisopropylbenzene, tris (hydroxyphenyl)methane, etc. and, as the amino group-having compound, there are illustrated aniline, p-aminodiphenylamine, etc. These quinonediazide photosensitizers may be used alone or as a mixture of two or more of them. In addition, as the quinonediazidesulfonic acid esters, esters between a polycondensation product of a phenol and an aldehyde or ketone and the quinonediazidesulfonic acid may also be used.

The ratio of the above-described quinonediazide compound to the alkali-soluble resin to be used varies depending upon the kinds of actually used quinonediazide compound and alkali-soluble resin but, in general, it is in the range of from 1:1 to 1:20, though the present invention not being limited thereto.

Chemically amplified resists are also preferably used in the present invention as the radiation-sensitive materials. The chemically amplified resists generates acid upon being irradiated with radiation, and this acid in turn catalyzes chemical change in the radiation-exposed areas to change solubility of the areas for a developer solution, thus a pattern being formed. For example, there are illustrated those which contain an acid-generating compound capable of generating an acid upon being exposed to radiation and a resin having an acid-sensitive group capable of being decomposed in the presence of an acid to produce an alkali-soluble group such as a phenolic hydroxyl group or a carboxyl group.

As the acid-generating compound capable of generating acid upon being exposed to radiation, there are illustrated bissulfonyldiazomethanes such as bis(isopropylsulfonyl) diazomethane, bissulfonylmethanes such as methylsulfonyl p-toluenesulfonylmethane, etc., sulfonylcarbonyl diazomethanes such as cyclohexylsulfonyl cyclohexylcarbonyl diazomethane, etc., sulfonylcarbonylalkanes such as 2-methyl-2-(4-methylphenylsulfonyl)propiophenone, etc., nitrobenzylsulfonates such as 2-nitrobenzyl p-toluenesulfonate, etc., alkyl or aryl sulfonates such as pyrogallol trismethane sulfonate, etc., benzoin sulfonates such as benzointosylate, etc., N-sulfonyloxyimides such as N-(trifluoromethylsulfonyloxy)phthalimide, etc., pyrrolidones such as (4-fluorobenzenesulfonyloxy)-3,4,6-trimethyl-2-pyrrolidone, etc., sulfonic acid esters such as 2,2,2-trifluoro-1-trifluoromethyl-1-(3-vinylphenyl)ethyl 4-chlorobenzene sulfonate, etc., and onium salts such as triphenylsulfoniummethane sulfonate. These compounds may be used alone or in combination of two or more.

The resin having an acid-labile group capable of being decomposed in the presence of an acid to produce an alkali-soluble group such as a phenolic hydroxyl group or a carboxyl group comprises an acid-labile group capable of being decomposed in the presence of an acid and an alkali-soluble resin moiety. As the acid-sensitive group, there are illustrated, for example, a 1-substituted ethyl group such as 1-methoxyethyl group, a 1-benzyloxy group, etc., a 1-branched alkyl group such as t-butyl group, etc., a silyl group such as a trimethylsilyl group, etc., a germyl group such as a trimethylgermyl group, etc., an alkoxycarbonyl group such as a t-butoxycarbonyl group, etc., an acyl group such as an acetyl group, etc. and a cyclic acid-decomposable group such as a tetrahydropyranyl group, a tetrahydrofuranyl group, a tetrahydrothiopyranyl group, a tetrahydrothiofuranyl group, etc. Of these acid-decomposable groups, t-butyl group, benzyl group, t-butoxycarbonyl group, tetrahydropyranyl group, tetrahydrofuranyl group, tetrahydrothiopyranyl group, tetrahydrothiofuranyl group, etc. are preferred.

As the alkali-soluble resin having alkali-soluble group such as phenolic hydroxyl group or carboxyl group, there are illustrated, for example, homopolymers or copolymers of vinyl monomers such as hydroxystyrene, hydroxy- α -methylstyrene, hydroxymethylstyrene, vinylbenzoic acid, carboxymethylstyrene, carboxymethoxystyrene, acrylic acid, methacrylic acid, crotonic acid, maleic acid, itaconic acid, citraconic acid, mesaconic acid, cinnamic acid, etc., copolymers of at least one of these monomers and other monomers, and polycondensation resins such as novolak resin.

In addition, as the chemically amplified resists, there are known different types which contain an alkali-soluble resin, an acid-generating agent, and a compound capable of being decomposed in the presence of an acid to decrease the effect of controllered solubility, or increase solubility of the alkali-soluble resin. Chemically amplified resists of this type can also be used in the present invention.

Further, known or well known various components such as sensitizers, surfactants, etc. may optionally be added to the radiation-sensitive composition of the present invention.

The amount of at least one selected from among the propylene glycol alkyl ethers and propylene glycol diacetate and other solvent based on the resist varies depending upon the kind of resist used and the kinds of propylene glycol alkyl ether or propylene glycol diacetate but, usually, it ranges from 50 to 3000 parts by weight, preferably from 70 to 2000 parts by weight, more preferably from 100 to 1000 parts by weight, per 100 parts by weight of resist solid components.

The radiation-sensitive composition of the present invention adapted for roller coating is prepared by dissolving a radiation-sensitive material, and if necessary optional various components in the aforementioned solvent and, if necessary, filtering the resulting solution. The thus prepared composition is coated on a substrate such as a liquid crystal display substrate using a roller coater in a prebaked thickness of usually 1.0 - 2.5 µm. The composition coated on the substrate is then prebaked, for example, on a hot plate to remove the solvent and form a radiation-sensitive resist layer. Prebaking temperature varies depending upon the kind of solvent or radiation-sensitive material used but, usually, prebaking is conducted at about 30 to about 200°C, preferably about 50 to 150°C.

After formation of the resist layer, exposure is conducted. The exposure is conducted using a known exposing apparatus such as a high pressure mercury lamp, a metal halide lamp, a super-high pressure mercury lamp, a KrF excimer laser, a soft X-ray irradiating apparatus, an electron beam-inscribing apparatus, or the like optionally through a mask. After the patternwise exposure, the exposed resist layer is optionally subjected to after-baking for improving developability, resolving power, pattern profile, etc., and is developed. After the development, dry etching may optionally be conducted by using, for example, gas plasma for removing an anti-reflective coating or the like to create a resist pattern.

Development of the above-described resist is usually conducted by using a developer solution utilizing difference in solubility for a solvent or an alkali solution between exposed areas and unexposed areas. As an alkaline developer solution, an aqueous solution or water-containing solution containing dissolved therein an inorganic alkali (e.g., sodium hydroxide, potassium hydroxide, sodium carbonate, sodium silicate, etc.), an amine (e.g., ammonia, ethylamine, diethylamine, triethylamine, diethylethanolamine, triethanolamine, benzylamine, etc.), an amide (e.g., formamide, etc.), a quaternary ammonium salt (e.g., tetramethylammonium hydroxide (TMAH), tetraethylammonium hydroxide, choline, etc.), a cyclic amine (e.g., pyrrole, piperadine, etc.) or the like is used.

The present invention is now described in more detail by reference to Examples and Comparative Examples which, however, are not construed to be limitative at all.

### Examples 1 to 6 and Comparative Example 1

A polycondensation product (novolak resin) between m-cresol/p-cresol (6/4) and formaldehyde and a condensation product (quinonediazide photosensitizer) between 2, 3,4-trihydroxybenzophenone and 1,2-naphthoquinonediazide-5-sulfonyl chloride were used, as radiation-sensitive material, in a proportion of 100:20 by weight and, after dissolving the material in various solvents shown in Table 2 to prepare solutions of 30 cP in viscosity. Each solution was coated on a Cr-layered glass substrate (300 x 360 x 1.1 mm) in a prebaked thickness of 1.5 µ m using a roller coater, RC-353-P, made by Dainippon Screen Seizou Kabushiki Kaisha. After coating, the substrates were subjected to prebaking (proximity: 100 seconds; direct: 100 seconds) on a 100°C direct hot plate. Viewing of the thus prebaked substrates under a sodium lamp (yellow lamp) gave the results shown in Table 2. Additionally, coating properties and drying properties in Table 2 were evaluated according to the following evaluation criteria.

### Coating properties:

A: No unevenness in coating thickness was observed, and no difference in brightness was observed when viewed as a liquid crystal display element under the yellow lamp.
B: Unevenness in coating thickness was scarcely observed, and no difference in brightness was observed when viewed as a liquid crystal display element under the yellow lamp.
C: Unevenness in coating thickness was observed, and difference in brightness was visually detected when viewed as a liquid crystal display element under the yellow lamp.
D: Unevenness and roughness in coating thickness was observed, and difference in brightness was clearly detected when viewed as a liquid crystal display element under the yellow lamp.

### Drying properties:

A: Drying was completed within a time 1.2 times as much as the standard time required for drying a coating containing PGMEA as a solvent.
B: Drying was completed within a time 1.5 times as much as the standard time required for drying a coating containing PGMEA as a solvent.
C: Drying was completed within a time 2 times as much as the standard time required for drying a coating containing PGMEA as a solvent.
D: Drying was completed only after a time 2 times as much as the standard time required for drying a coating containing PGMEA as a solvent.

Additionally, % in the following tables means % by weight.

**Table 2**

| | Formulation of Solvent | | Coating Properties | Drying Properties |
|---|---|---|---|---|
| Example 1 | PGMEA 60% | PPh 40% | A | D |
| Example 2 | PGMEA 60% | TPM 40% | A | D |
| Example 3 | PGMEA 60% | DPnB 40% | A | C |
| Example 4 | PGMEA 60% | PGDA 40% | A | B |
| Example 5 | PGMEA 60% | DPM 40% | A | A |
| Example 6 | PGMEA 60% | Butycello 40% | B | A |
| Comparative Example 1 | PGMEA 100% | | D | A |

It can be seen from Table 2 that coating properties can be improved markedly by using propylene glycol phenyl ether (PPh), tripropylene glycol methyl ether (TPM), dipropylene glycol n-butyl ether (DPnB), propylene glycol diacetate (PGDA), dipropylene glycol methyl ether (DPM) or ethylene glycol monobutyl ether (butycello) having a boiling point of 170 to 250°C, kinematic viscosity of 2cSt or more at 25°C, and a relative evaporation rate of 10 or less taking the evaporation rate of n-butyl ester as 100, in combination with the other solvent of propylene glycol methyl ether acetate (PGMEA).

### Examples 7 to 10

The same procedures as in Example 1 were conducted except for using as the solvent those shown in Table 3. Thus, there were obtained the results shown in Table 3.

**Table 3**

| | Formulation of Solvent | | Coating Properties | Drying Properties |
|---|---|---|---|---|
| Example 7 | PGMEA 60% | TPM 40% | A | D |
| Example 8 | PGMEA 70% | TPM 30% | B | c |
| Example 9 | PGMEA 80% | TPM 20% | B | B |
| Example 10 | PGMEA 90% | TPM 10% | B | B |

It is seen from Table 3 that coating properties can be increasingly improved as the amount of tripropylene glycol methyl ether (TPM) is increased.

### Examples 11 to 14

The same procedures as in Example 1 were conducted except for using as the solvent those shown in Table 4. Thus, there were obtained the results shown in Table 4.

**Table 4**

| | Formulation of Solvent | | Coating Properties | Drying Properties |
|---|---|---|---|---|
| Example 11 | PGMEA 90% | PGDA 10% | B | A |
| Example 12 | PGMEA 80% | PGDA 20% | B | A |
| Example 13 | PGMEA 70% | PGDA 30% | A | A |
| Example 14 | PGMEA 60% | PGDA 40% | A | B |

It is seen from Table 4 that coating properties can be increasingly improved as the amount of propylene glycol diacetate (PGDA) is increased similarly with TPM.

### Examples 15 to 17

The same procedures as in Example 1 were conducted except for using as the solvent those shown in Table 5. Thus, there were obtained the results shown in Table 5.

**Table 5**

| | Formulation of Solvent | | Drying Properties | Coating Properties |
|---|---|---|---|---|
| Example 15 | PGMEA 80% | DPM 20% | B | A |
| Example 16 | PGMEA 70% | DPM 30% | A | A |
| Example 17 | PGMEA 60% | DPM 40% | A | B |

It is seen from Table 5 that coating properties can be increasingly improved as the amount of dipropylene glycol methyl ether (DPM) is increased similarly with TPM and PGDA.

### Examples 18 to 21

The same procedures as in Example 1 were conducted except for using as the solvent those shown in Table 6. Thus, there were obtained the results shown in Table 6.

**Table 6**

| | Formulation of Solvent | | | Coating Properties | Drying Properties |
|---|---|---|---|---|---|
| Example 18 | PGMEA 55% | TPM 40% | PGME 5% | A | D |
| Example 19 | PGMEA 50% | TPM 40% | PGME 10% | A | C |
| Example 20 | PGMEA 55% | TPM 40% | nBA 5% | A | D |
| Example 21 | PGMEA 50% | TPM 40% | nBA 10% | A | C |

It is seen from Table 6 that coating properties can also be improved by using two solvents as the other solvent.

### Examples 22 to 25 and Comparative Example 2

The same procedures as in Example 1 were conducted except for using as the solvent those shown in Table 7. Thus, there were obtained the results shown in Table 7.

**Table 7**

| | Formulation of Solvent | | Coating Properties | Drying Properties |
|---|---|---|---|---|
| Example 22 | EGA 60% | TPM 40% | A | D |
| Example 23 | EGA 70% | TPM 30% | A | D |
| Example 24 | EGA 80% | TPM 20% | B | C |
| Example 25 | EGA 90% | TPM 10% | B | B |
| Comparative Example 2 | EGA 100% | | C | B |

It is seen from Table 7 that coating properties can also be markedly improved by using, as the other solvent, ethylene glycol monoethyl ether acetate (EGA) as is the same with propylene glycol methyl ether acetate (PGMEA).

Additionally, though drying properties generally tend to be deteriorated with the improvement of coating properties as is seen from the above results, it does not spoil industrial utility. For example, in using these radiation-sensitive compositions for manufacturing liquid crystal display elements, difference in brightness is decreased owing to improved coating properties in spite of slight deterioration of drying properties, thus products with extremely high quality being obtained. Therefore, in actual manufacturing, it suffices to select solvent formulation taking the balance between coating properties and drying properties into consideration.

As has been described hereinbefore, the present invention provides a remarkable advantage that a coating layer can be formed with no coating unevenness by coating a radiation-sensitive composition on a substrate, said composition containing as one component of mixed solvent at least one member selected from among propylene glycol alkyl ethers having a boiling point of 170 to 250°C, kinematic viscosity of 2 cSt or more at 25°C, and a relative evaporation rate of 10 or less taking the evaporation rate of n-butyl acetate as 100 and propylene glycol diacetate.

In addition, since no coating unevenness takes place when the radiation-sensitive composition of the present invention is used, there is provided another marked advantage that liquid crystal element displays with high quality which do not present uneven brightness can be manufactured using a roller coater.

While the invention has been described above with reference to specific embodiments thereof, it is apparent that many changes, modifications, and variations can be made without departing from the inventive concept disclosed herein. Accordingly, it is intended to embrace all such changes, modifications, and variations that fall within the spirit and broad scope of the appended claims.

## Claims

1. A radiation-sensitive composition adapted for roller coating, which contains as a solvent a mixed solvent comprising
a)at least one selected from among propylene glycol alkyl ethers having a boiling point of 170 to 250°C, a kinematic viscosity of 2 cSt or more at 25°C, and a relative evaporation rate of 10 or less taking the evaporation rate of n-butyl acetate as 100 and propylene glycol diacetate and
b)other solvent or solvents.

2. The radiation-sensitive composition adapted for roller coating described in claim 1, wherein said propylene glycol alkyl ether is at least one selected from among propylene glycol n-butyl ether, propylene glycol phenyl ether, dipropylene glycol methyl ether, dipropylene glycol n-butyl ether, and tripropylene glycol methyl ether.

3. The radiation-sensitive composition adapted for roller coating described in claim 1, wherein said other solvent is at least one selected from among propylene glycol monomethyl ether acetate, propylene glycol monomethyl ether, ethylene glycol monoethyl ether acetate, ethylene glycol monobutyl ether, ethyl lactate and n-butyl acetate.

4. The radiation-sensitive composition adapted for roller coating described in claim 2, wherein said other solvent is at least one selected from among propylene glycol monomethyl ether acetate, propylene glycol monomethyl ether, ethylene glycol monoethyl ether acetate, ethylene glycol monobutyl ether, ethyl lactate and n-butyl acetate.
